# EUROPEAN PATENT APPLICATION

(11) **EP 4 550 425 A1**
(43) Date of publication of application: **07.05.2025**
(21) Application number: 23899442.0
(22) Date of filing: 03.08.2023
(51) Int. Cl.: H01L 31/068, H01L 31/0224, H01L 31/18

(54) **SOLAR CELL AND PREPARATION METHOD THEREFOR**

(30) Priority: 05.12.2022 CN 202211547103
(71) Applicant: Trina Solar Co., Ltd, Changzhou, Jiangsu 213031 (CN)
(72) Inventor: WANG, Yao, hangzhou, Jiangsu 213031 (CN); CHEN, Daming, hangzhou, Jiangsu 213031 (CN)
(74) Representative: Arnold & Siedsma
(86) International application number: PCT/CN2023/110897
(87) International publication number: WO 2024/119857

(57) **Abstract**

The present disclosure provides a solar cell and a method for preparing the same. The solar cell includes a semiconductor substrate (100), a first heavily doped layer (111), a front electrode (120), an emitter layer (130), and a back electrode (140). The first heavily doped layer (111) and the front electrode (120) are disposed on the front surface of the semiconductor substrate (100). The first heavily doped layer is disposed between the front electrode (120) and the semiconductor substrate (100). The emitter layer (130) is disposed between the back electrode (140) and the semiconductor substrate (100).

## Description

This application claims priority to Chinese patent application No. 2022115471030, filed on December 5, 2022, and titled "SOLAR CELL AND PREPARATION METHOD THEREFOR", the content of which is hereby incorporated herein in its entirety by reference.

### TECHNICAL FIELD

The present disclosure relates to the technical field of solar cells, particularly to a solar cell and a method for preparing the same.

### BACKGROUND

Solar cells are semiconductor components that utilize the photovoltaic effect to convert light energy into electrical energy. The basic structure of a solar cell is typically a p-n junction. However, a single p-n junction faces the issue of significant carrier recombination, which leads to efficiency degradation. Therefore, modern solar cells often incorporate additional functional structures on the basis of the p-n junction.

Passivated emitter and rear contact (PERC) solar cells are a common type of solar cell, which introduces an additional passivation layer on the back side of the substrate to effectively reduce carrier recombination at the back electrodes, increase open-circuit voltage, and enhance backside reflection, and thus has drawn widespread attention. In practical applications, due to rapid development of technology, the conversion efficiency of PERC cells in mass production has gradually approached its theoretical limit. Thus, further improving the conversion efficiency of solar cells within the constraints of existing equipment has become a critical challenge for the industry.

### SUMMARY

In view of the above, various embodiments of the present disclosure provide a solar cell, including a semiconductor substrate, a first heavily doped layer, a front electrode, an emitter layer, and a back electrode.

The semiconductor substrate is first-type doped and includes opposing front and back surfaces.

The first heavily doped layer and the front electrode are disposed on the front surface of the semiconductor substrate. The first heavily doped layer is first-type doped. A doping concentration of the first heavily doped layer is higher than a doping concentration of the semiconductor substrate. The first heavily doped layer is disposed between the front electrode and the semiconductor substrate. The front electrode is electrically connected to the semiconductor substrate through the first heavily doped layer.

The emitter layer and the back electrode are disposed on the back surface of the semiconductor substrate. The emitter layer is second-type doped, and the second type is different from the first type. The emitter layer is disposed between the back electrode and the semiconductor substrate.

In some embodiments of the present disclosure, an orthographic projection of the front electrode on the semiconductor substrate is located within an orthographic projection of the first heavily doped layer on the semiconductor substrate.

In some embodiments of the present disclosure, the front electrode is in direct contact with the first heavily doped layer.

In some embodiments of the present disclosure, the first heavily doped layer is stacked on the semiconductor substrate.

In some embodiments of the present disclosure, a portion of the first heavily doped layer is embedded within the semiconductor substrate.

In some embodiments of the present disclosure, the solar cell further includes a second heavily doped layer disposed on the front surface of the semiconductor substrate. The second heavily doped layer is first-type doped, and a doping concentration of the second heavily doped layer is higher than the doping concentration of the semiconductor substrate but lower than the doping concentration of the first heavily doped layer. An electric field that hinders movement of front side carriers is formed between the second heavily doped layer and the semiconductor substrate.

In some embodiments of the present disclosure, the doping concentration of the first heavily doped layer ranges from 1×10¹⁸cm⁻³ to 3×10¹⁸cm⁻³, while the doping concentration of the second heavily doped layer ranges from 5×10¹⁶cm⁻³ to 9×10¹⁷cm⁻³.

In some embodiments of the present disclosure, the orthographic projection of the first heavily doped layer on the semiconductor substrate is located within an orthographic projection of the second heavily doped layer on the semiconductor substrate.

In some embodiments of the present disclosure, at least part of the first heavily doped layer is embedded within the second heavily doped layer.

In some embodiments of the present disclosure, the first heavily doped layer is exposed from the second heavily doped layer and is in contact with the semiconductor substrate.

In some embodiments of the present disclosure, the first heavily doped layer is spaced apart from the semiconductor substrate by the second heavily doped layer.

In some embodiments of the present disclosure, the second heavily doped layer is stacked on the semiconductor substrate.

In some embodiments of the present disclosure, a portion of the first heavily doped layer is embedded within the semiconductor substrate.

In some embodiments of the present disclosure, the first heavily doped layer is embedded within the second heavily doped layer, and a top surface of the first heavily doped layer is flush with a top surface of the second heavily doped layer.

In some embodiments of the present disclosure, the second heavily doped layer is embedded within the semiconductor substrate, the first heavily doped layer is embedded within the second heavily doped layer, and the top surfaces of the first heavily doped layer, the second heavily doped layer, and the semiconductor substrate are flush with each other.

In some embodiments of the present disclosure, the first heavily doped layer is stacked on a side of the second heavily doped layer away from the semiconductor substrate.

In some embodiments of the present disclosure, the second heavily doped layer is stacked on the semiconductor substrate.

In some embodiments of the present disclosure, the first type doping is p-type doping, and the second type doping is n-type doping.

In some embodiments of the present disclosure, the first heavily doped layer includes a first-type doped polysilicon layer, and the solar cell further includes a first tunneling oxide layer disposed between the first-type doped polysilicon layer and the semiconductor substrate.

In some embodiments of the present disclosure, the emitter layer includes a second-type doped polysilicon layer, and the solar cell further includes a second tunneling oxide layer disposed between the second-type doped polysilicon layer and the semiconductor substrate.

In some embodiments of the present disclosure, the emitter layer includes a first region and a second region located outside the first region. The back electrode is disposed on the first region, and a thickness of the first region is greater than a thickness of the second region.

In some embodiments of the present disclosure, a thickness difference between the first region and the second region is in a range from 20 nm to 120 nm.

In some embodiments of the present disclosure, the solar cell further includes a layer stacked on the front surface.

In some embodiments of the present disclosure, a passivation film structure is disposed on the back surface, and the passivation film structure includes a first dielectric layer and a second dielectric layer sequentially stacked in a direction away from the semiconductor substrate.

In some embodiments of the present disclosure, the first dielectric layer is a silicon oxide layer or a silicon oxynitride layer, and the second dielectric layer is an aluminum oxide layer.

In some embodiments of the present disclosure, a thickness of the first dielectric layer is in a range from 0.1 nm to 2 nm, and a thickness of the second dielectric layer is in a range from 3 nm to 20 nm.

Furthermore, according to some additional embodiments of the present disclosure, a method for preparing the above-described solar cell is further provided, and the method includes following steps:
forming a first heavily doped layer on a front surface of a semiconductor substrate, wherein both the semiconductor substrate and the first heavily doped layer are first-type doped, and a doping concentration of the first heavily doped layer is higher than a doping concentration of the semiconductor substrate;
forming a front electrode on a side of the first heavily doped layer away from the semiconductor substrate, wherein the front electrode is electrically connected to the semiconductor substrate through the first heavily doped layer;
forming an emitter layer on a back surface of the semiconductor substrate, wherein the emitter layer is second-type doped, and the second-type doping is different from the first-type doping; and
forming a back electrode on a side of the emitter layer away from the semiconductor substrate.

In some embodiments of the present disclosure, the method further includes a step of forming a second heavily doped layer on the front surface of the semiconductor substrate. The second heavily doped layer is first-type doped. A doping concentration of the second heavily doped layer is higher than the doping concentration of the semiconductor substrate and lower than the doping concentration of the first heavily doped layer. An electric field that hinders movement of front side carriers is formed between the second heavily doped layer and the semiconductor substrate.

In some embodiments of the present disclosure, the step of forming the second heavily doped layer is performed before the step of forming the first heavily doped layer. The step of forming the first heavily doped layer includes: forming the first heavily doped layer at least partially within the second heavily doped layer, such that at least part of the first heavily doped layer is encapsulated within the second heavily doped layer.

In some embodiments of the present disclosure, the step of forming the first heavily doped layer at least partially within the second heavily doped layer includes:
forming a through-hole in the second heavily doped layer, the through-hole penetrating through the second heavily doped layer and exposing the semiconductor substrate; introducing a doping material into the through-hole; and sintering the doping material with a material of the semiconductor substrate, thereby forming the first heavily doped layer.

In some embodiments of the present disclosure, a groove is formed in the second heavily doped layer, with the second heavily doped layer defining a bottom of the groove. A doping material is introduced into the groove, and the doping material is sintered with a material of the second heavily doped layer, thereby forming the first heavily doped layer.

In some embodiments of the present disclosure, a material of the second heavily doped layer is further doped through laser doping, thereby forming the first heavily doped layer.

In some embodiments of the present disclosure, the step of forming the second heavily doped layer is performed before the step of forming the first heavily doped layer. The first heavily doped layer is formed on a side of the second heavily doped layer away from the semiconductor substrate, and the formed first heavily doped layer is stacked on the second heavily doped layer.

In some embodiments of the present disclosure, the method further includes a step of forming a passivation film structure on the front surface of the semiconductor substrate. The step of forming the passivation film structure includes sequentially forming a first dielectric layer and a second dielectric layer stacked in a direction away from the semiconductor substrate.

In some embodiments of the present disclosure, the method further includes a step of forming a passivation film structure on the back surface of the semiconductor substrate. The step of forming the passivation film structure includes sequentially forming a first dielectric layer and a second dielectric layer stacked in a direction away from the semiconductor substrate.

In some embodiments of the present disclosure, the emitter layer includes a first region and a second region located outside the first region. In the step of forming the back electrode, the back electrode is formed on a side of the first region away from the semiconductor substrate;
after forming the emitter layer, the method further includes: etching the second region, such that a thickness of the first region is greater than a thickness of the second region.

The solar cell provided in at least one of above embodiments includes the first heavily doped layer and the front electrode disposed on the front surface of the semiconductor substrate, and includes the emitter layer and the back electrode disposed on the back surface of the semiconductor substrate. In the present disclosure, the p-n junction of the solar cell is located on the back surface of the semiconductor substrate, and the first heavily doped layer is disposed on the front surface to form a high-low junction with the semiconductor substrate. This structure can suppress recombination caused by photo-generated carriers migrating to the back surface. Moreover, the first heavily doped layer can enhance the electrical conductivity between the front electrode and the semiconductor substrate, effectively improving the conversion efficiency of the solar cell.

The above description is only a summary of the technical solutions of the present disclosure. The following detailed description with reference to the accompanying drawings and embodiments is provided to enable those skilled in the art to better understand, make and use the technical solutions of the present disclosure according to the specification.

### BRIEF DESCRIPTION OF THE DRAWINGS

In order to more clearly describe the embodiments of the present disclosure, the accompanying drawings to be used in the description of the embodiments will be described briefly. Obviously, the drawings described below are only for some embodiments of the present disclosure. For ordinary skilled persons in the art, other drawings can also be obtained based on the following drawings without creative work.
FIG. 1 is a schematic structural view of a solar cell according to some embodiments of the present disclosure.
FIG. 2 is a schematic structural regional view of an emitter layer in the solar cell of FIG. 1.
FIG. 3 is a schematic structural view of a solar cell according to some other embodiments of the present disclosure.
FIG. 4 is a schematic structural view of a solar cell according to some other embodiments of the present disclosure.
FIG. 5 is a schematic structural view of a solar cell according to some other embodiments of the present disclosure.
FIG. 6 is a schematic structural view of a solar cell according to some other embodiments of the present disclosure.
FIG. 7 is a schematic structural view of a solar cell according to some other embodiments of the present disclosure.

### DETAILED DESCRIPTION

In order to facilitate the understanding of the present disclosure, the present disclosure will be comprehensively described with reference to the drawings. Main embodiments of the present disclosure are shown in the drawings. However, the present disclosure can be implemented in many different forms and therefore is not limited to the embodiments described herein. On the contrary, the purpose of providing these embodiments is to make the understanding of the present disclosure more thorough and comprehensive.

Unless defined otherwise, all technical and scientific terms used herein have the same meaning as commonly understood by those skilled in the art of the present disclosure. The terms used in the specification of the present disclosure are for the purpose of describing exemplary examples only and are not intended to limit the present disclosure. The term "and/or" as used herein refers to any and all combinations of one or more items listed therewith.

It should be understood that when an element or layer is referred to as being "on", "adjacent to", "connected to", or "coupled to" another element or layer, it can be directly on, adjacent to, connected to, or coupled to the other element or layer, or an intermediate element or layer can be present. Electrical connection refers to electrical current conduction between multiple elements, which specifically can be achieved by direct contact between one element and another element, or through an additional electrically conducting element between the two elements. In contrast, when an element is referred to as being "directly on", "directly adjacent to", "directly connected to", or "in contact with" another element or layer, there is no intermediate element or layer. It can be understood that although the terms first, second, third etc. can be used to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section described below can be termed as a second element, component, region, layer, or section without departing from the teachings of the present disclosure.

The spatial relation terms such as "below", "under", "beneath", "above", "on", "over", etc., may be used herein to conveniently describe the relationships of an element or a feature with other elements or features shown in the drawings. It should be understood that besides the orientations of the elements or features shown in the drawings, the spatial relation terms are intended to cover other different orientations in use or operation. For example, if the device shown in the drawings are placed upside down, an element or feature which was described as "below", "under", or "beneath" other elements or features will be "above" or "over" the other elements or features. Thus, the exemplary terms "below", "under", and "beneath" can cover the orientations of above and below. The device can also be positioned in other different orientations (e.g., rotating 90 degrees or at other orientations), and the spatial relation terms used herein can be correspondingly interpreted.

The terminology used herein is for the purpose of describing specific embodiments only and is not intended to limit the present disclosure. As used herein, the singular form with "a", "an", "the", or "said" are intended to cover the plural form as well, unless the context clearly indicates otherwise. It should also be understood that the terms "be composed of" and/or "include", when used in the present disclosure, identify the presence of the stated features, integers, steps, operations, elements and/or parts, but do not exclude presence or addition of one or more other features, integers, steps, operations, elements, parts and/or groups. As used herein, the term "and/or" means that any or all combinations of the listed items can be employed.

An embodiment of the present disclosure provides a semiconductor structure, including a semiconductor substrate, a first heavily doped layer, a front electrode, an emitter layer, and a back electrode. The semiconductor substrate is first-type doped and includes opposing front and back surfaces. The first heavily doped layer and the front electrode are disposed on the front surface of the semiconductor substrate. The first heavily doped layer is first-type doped. A doping concentration of the first heavily doped layer is higher than that of the semiconductor substrate. The first heavily doped layer is disposed between the front electrode and the semiconductor substrate. The front electrode is electrically connected to the semiconductor substrate through the first heavily doped layer. The emitter layer and the back electrode are disposed on the back surface of the semiconductor substrate. The emitter layer is second-type doped. The emitter layer is disposed between the back electrode and the semiconductor substrate.

It can be understood that a solar cell typically receives light from only one side. In the above-described solar cell, the front side refers to the side of the solar cell that receives light, while the back side is opposite to the front side. In a conventional solar cell, the p-n junction is commonly located at the front surface of the silicon wafer. In the present disclosure, the p-n junction of the solar cell is located on the back surface of the semiconductor substrate, and the first heavily doped layer is disposed on the front surface to form a high-low junction with the semiconductor substrate. This structure can suppress recombination caused by photo-generated carriers migrating to the back surface. Moreover, the first heavily doped layer can enhance the electrical conductivity between the front electrode and the semiconductor substrate, effectively improving the conversion efficiency of the solar cell.

In some examples of the present embodiment, the first-type doping is p-type doping, and the second-type doping is n-type doping. By adopting the p-type doped semiconductor substrate, the costs for raw materials can be effectively reduced.

In some examples of the present embodiment, an orthographic projection of the front electrode on the semiconductor substrate is located within an orthographic projection of the first heavily doped layer on the semiconductor substrate. It can be understood that the orthographic projection on the semiconductor substrate refers to the projection of the first heavily doped layer on the semiconductor substrate along the direction perpendicular to the front surface of the semiconductor substrate. By positioning the orthographic projection of the front electrode entirely within the orthographic projection of the first heavily doped layer, the front electrode can be fully spaced from the semiconductor substrate by the first heavily doped layer, so that the first heavily doped layer can more effectively suppress carrier recombination while more effectively improving the electrical conductivity between the front electrode and the semiconductor substrate.

In some examples of the present embodiment, the front electrode can be in direct contact with the first heavily doped layer, forming an ohmic contact between the front electrode and the first heavily doped layer, so as to enhance the carrier extraction efficiency. Optionally, the first heavily doped layer can be confined to the region between the front electrode and the semiconductor substrate instead of fully covering the front surface of the semiconductor substrate. Optionally, the front electrode is spaced from the semiconductor substrate by the first heavily doped layer.

In some examples of the present embodiment, the first heavily doped layer is stacked on the semiconductor substrate, or a portion of the first heavily doped layer is embedded within the semiconductor substrate.

In some examples of the present embodiment, the solar cell can further include a second heavily doped layer disposed on the front surface. The second heavily doped layer is also first-type doped. A doping concentration of the second heavily doped layer is higher than that of the semiconductor substrate but lower than that of the first heavily doped layer. An electric field that hinders the movement of front side carriers is formed between the second heavily doped layer and the semiconductor substrate. Since the second heavily doped layer has a higher doping concentration, an electric potential of the second heavily doped layer is greater than that of the semiconductor substrate, creating a built-in electric field between the second heavily doped layer and the semiconductor substrate, and the built-in electric field directs from the second heavily doped layer to the semiconductor substrate. When the charge carriers have a movement direction from the semiconductor substrate to the front electrode, which is in opposition to the built-in electric field, the charge carriers can be blocked by the built-in electric field. This structure suppresses potential-induced degradation (PID) in the solar cell, further enhancing the conversion efficiency of the solar cell.

In some examples of the present embodiment, the doping concentration of the first heavily doped layer ranges from 1×10¹⁸cm⁻³ to 3×10¹⁸cm⁻³, while the doping concentration of the second heavily doped layer ranges from 5×10¹⁶cm⁻³ to 9×10¹⁷cm⁻³. It can be understood that the dopant element in the first and second heavily doped layers can be a group III element, such as boron, aluminum, gallium, or combinations thereof.

In some examples of the present embodiment, the orthographic projection of the first heavily doped layer on the semiconductor substrate is located within an orthographic projection of the second heavily doped layer on the semiconductor substrate. By positioning the orthographic projection of the first heavily doped layer entirely within the orthographic projection of the second heavily doped layer, the movement path of the charge carriers from the semiconductor substrate to the front electrode is within the built-in electric field, which can suppress the potential-induced degradation more effectively.

In some examples of the present embodiment, at least part of the first heavily doped layer is embedded within the second heavily doped layer. Optionally, the first heavily doped layer is exposed from the second heavily doped layer to make direct contact with the semiconductor substrate, or the first heavily doped layer is spaced apart from the semiconductor substrate by the second heavily doped layer. The first heavily doped layer can be exposed from the second heavily doped layer in a manner that the surface of the first heavily doped layer is flush with the surface of the second heavily doped layer, or in a manner that the first heavily doped layer protrudes from at least one surface of the second heavily doped layer.

In some examples of the present embodiment, the second heavily doped layer is stacked on the semiconductor substrate. Optionally, a portion of the first heavily doped layer is embedded within the semiconductor substrate; alternatively, the first heavily doped layer is embedded within the second heavily doped layer, and a top surface of the first heavily doped layer is flush with a top surface of the second heavily doped layer.

In some examples of the present embodiment, the second heavily doped layer is embedded within the semiconductor substrate, the first heavily doped layer is embedded within the second heavily doped layer, and the top surfaces of the first heavily doped layer, the second heavily doped layer, and the semiconductor substrate are flush with each other.

In other examples of the present embodiment, the first heavily doped layer can be stacked on a side of the second heavily doped layer away from the semiconductor substrate. Optionally, the second heavily doped layer is stacked on the semiconductor substrate, and the first heavily doped layer is stacked on the side of the second heavily doped layer away the semiconductor substrate. As a result, the first heavily doped layer is completely spaced from the semiconductor substrate by the second heavily doped layer. By separating the first heavily doped layer from the semiconductor substrate via the second heavily doped layer with a lower doping concentration, carrier diffusion and recombination caused by a high doping concentration can be reduced, while the first heavily doped layer is allowed to have a high doping concentration, further enhancing the electrical conductivity between the front electrode and the semiconductor substrate. Overall, this structure can effectively improve the conversion efficiency of the solar cell.

In some examples of the present embodiment, the second heavily doped layer can entirely cover the semiconductor substrate or be only disposed on a specific region of the substrate. The entirely covering of the semiconductor substrate with the second heavily doped layer facilitates the formation of the built-in electric field across the entire surface of the substrate, effectively suppressing the potential-induced degradation.

In some examples of the present embodiment, the first heavily doped layer includes a first-type doped polysilicon layer. The solar cell further includes a first tunneling oxide layer disposed between the first-type doped polysilicon layer and the semiconductor substrate. The first-type doped polysilicon layer and the first tunneling oxide layer together form a passivating contact structure, which can significantly reduce recombination caused by contact between the front electrode and the semiconductor substrate, thereby further improving the efficiency of the solar cell.

In some examples of the present embodiment, the emitter layer includes a second-type doped polysilicon layer. The solar cell further includes a first tunneling oxide layer disposed between the emitter layer and the semiconductor substrate. In this example, the second-type doped polysilicon and the second tunneling oxide layer together form a passivating contact structure, which can significantly reduce recombination caused by contact between the back electrode and the semiconductor substrate, thereby further improving the efficiency of the solar cell.

In some examples of the present embodiment, the solar cell further includes a passivation film structure disposed on the front surface. The passivation film structure includes an aluminum oxide layer and a silicon oxide layer stacked with each other, with the silicon oxide layer disposed on a side of the aluminum oxide layer adjacent to the semiconductor substrate. In conventional art, a passivation film may only include an aluminum oxide layer. In contrast, in the present disclosure, the aluminum oxide layer is stacked with the silicon oxide layer, thereby further enhancing interface passivation effect, thereby increasing open-circuit voltage and conversion efficiency.

In some examples of the present embodiment, the solar cell further includes a passivation film structure disposed on the back surface. The passivation film structure includes a first dielectric layer and a second dielectric layer sequentially stacked in a direction away from the semiconductor substrate.

In some examples of the present embodiment, the first dielectric layer is a silicon oxide layer or a silicon oxynitride layer, and the second dielectric layer is an aluminum oxide layer.

In some examples of the present embodiment, a thickness of the first dielectric layer is in a range from 0.1 nm to 2 nm.

In some examples of the present embodiment, a thickness of the second dielectric layer is in a range from 3 nm to 20 nm.

In some examples of the present embodiment, the above-described passivation film structure is disposed on the back surface of the semiconductor substrate, and the solar cell further includes a first refractive layer disposed on the side of the passivation film structure away from the semiconductor substrate. A refractive index of the first refractive layer is higher than that of the second dielectric layer. Optionally, the refractive index of the first refractive layer is in a range from 1.5 to 2.4. Optionally, a thickness of the first refractive layer is in a range from 1 nm to 80 nm.

Optionally, the first refractive layer can include a silicon-containing layer, such as a silicon oxide layer, a silicon oxynitride layer, a silicon nitride layer, a silicon carbide layer, or any combinations thereof. Optionally, the first refractive layer can include one or more refractive sub-layers, for example, a third dielectric layer, which can be a stacked structure of silicon nitride, silicon oxynitride, and silicon carbide layers with varying refractive indexes. For another example, the third dielectric layer can be a stacked structure of multiple silicon nitride layers, a stacked structure of multiple silicon oxynitride layers, or a stacked structure of multiple silicon carbide layers. Optionally, the first refractive layer includes multiple refractive sub-layers stacked with each other, and the refractive indexes of the multiple refractive sub-layers increase sequentially in the direction away from the semiconductor substrate. The first refractive layer with a relatively high refractive index can enhance light reflection at the back side of the solar cell, thus improving the absorption and utilization of light.

In some examples of the present embodiment, the emitter layer includes a first region and a second region. The back electrode is disposed on the first region. A thickness of the first region is greater than a thickness of the second region. The first region refers to the region of the emitter layer corresponding to the back electrode. For example, an orthographic projection of the first region on the semiconductor substrate can coincide with or encompass an orthographic projection of the back electrode on the semiconductor substrate. The back electrode is electrically connected to the emitter layer. Optionally, the back electrode can be in direct contact with the emitter layer, or be electrically connected to the emitter layer via another electrically conductive structure.

The thicker first region of the emitter layer can effectively prevent diffusion of material from the back electrode into the emitter layer and the tunneling oxide layer, thereby ensuring the passivating contact effect and improving the conversion efficiency. On the other hand, the thinner second region of the emitter layer can reduce light absorption, thereby reducing current loss of the solar cell, and further improving the conversion efficiency. Overall, compared to an emitter layer of uniform thickness, this emitter layer can effectively enhance the efficiency of the solar cell.

In some examples of the present embodiment, a thickness difference between the first region and the second region is in a range from 20 nm to 120 nm.

In some examples of the present embodiment, the back electrode can be a line-shaped electrode.

In some examples of the present embodiment, a material of the back electrode can include a metal, such as aluminum, silver, copper, gold, or any combinations thereof.

In some examples of the present embodiment, the solar cell further includes an anti-reflection layer. The anti-reflection layer is configured to increase the proportion of light entering the semiconductor substrate. A material of the anti-reflection layer can include silicon nitride.

The present disclosure further provides a method for preparing the above-described solar cell. The method includes following steps:
forming a first heavily doped layer on a front surface of a semiconductor substrate, wherein both the semiconductor substrate and the first heavily doped layer are first-type doped, and a doping concentration of the first heavily doped layer is higher than a doping concentration of the semiconductor substrate; forming a front electrode on a side of the first heavily doped layer away from the semiconductor substrate; forming an emitter layer on a back surface of the semiconductor substrate, wherein the emitter layer is second-type doped, and the second-type doping is different from the first-type doping; and forming a back electrode on a side of the emitter layer away from the semiconductor substrate.

In some examples of the present embodiment, the method further includes a step of forming a second heavily doped layer on the front surface of the semiconductor substrate. The second heavily doped layer is first-type doped. A doping concentration of the second heavily doped layer is higher than the doping concentration of the semiconductor substrate and lower than the doping concentration of the first heavily doped layer. An electric field that hinders movement of front side carriers is formed between the second heavily doped layer and the semiconductor substrate.

It can be understood that the first heavily doped layer can be formed by further doping a region of an already formed structure, or can be formed from an additional layer of doping material.

In some examples of the present embodiment, the step of forming the second heavily doped layer is performed before the step of forming the first heavily doped layer. The first heavily doped layer is formed on a side of the second heavily doped layer away from the semiconductor substrate, and the formed first heavily doped layer is stacked on the second heavily doped layer. In this case, the step of forming the first heavily doped layer can include: forming a first-type doped polysilicon layer stacked on the second heavily doped layer, thereby forming the first heavily doped layer.

In other examples of the present embodiment, the step of forming the second heavily doped layer is performed before the step of forming the first heavily doped layer. The step of forming the first heavily doped layer includes: forming the first heavily doped layer at least partially within the second heavily doped layer, such that at least part of the first heavily doped layer is encapsulated within the second heavily doped layer. For example, a through-hole can be formed in the second heavily doped layer, with the through-hole penetrating through the second heavily doped layer and exposing the semiconductor substrate, and a doping material can be introduced into the through-hole. The doping material can be then sintered with a material of the semiconductor substrate, thereby forming the first heavily doped layer. Alternatively, in some examples of the present embodiment, a groove can be formed in the second heavily doped layer, with the second heavily doped layer defining a bottom of the groove, and a doping material can be introduced into the groove. The doping material can be then sintered with a material of the second heavily doped layer, thereby forming the first heavily doped layer. Alternatively, in some examples of the present embodiment, a material of the second heavily doped layer is further doped through laser doping, thereby forming the first heavily doped layer.

In some examples of the present embodiment, the method further includes a step of forming a passivation film structure on the front surface and/or the back surface. The step of forming the passivation film structure includes: sequentially forming a first dielectric layer and a second dielectric layer stacked in a direction away from the semiconductor substrate.

Optionally, the first dielectric layer can be a silicon oxide layer or a silicon oxynitride layer, and the second dielectric layer can be an aluminum oxide layer.

In some examples of the present embodiment, the emitter layer includes a first region and a second region located outside the first region. In the step of forming the back electrode, the back electrode is formed on a side of the first region away from the semiconductor substrate. After forming the emitter layer, the method further includes: etching the second region, such that a thickness of the first region is greater than a thickness of the second region.

To facilitate understanding of the structure of the solar cell in the present disclosure, the present disclosure further provides six embodiments of the solar cell.

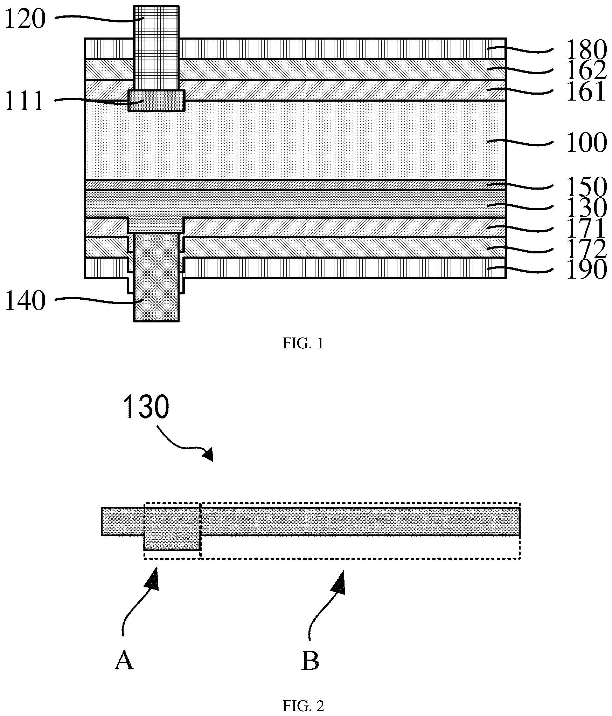

FIG. 1 shows a solar cell. Referring to FIG. 1, the solar cell includes a semiconductor substrate 100, a first heavily doped layer 111, a front electrode 120, an emitter layer 130, and a back electrode 140. The first heavily doped layer 111 and the front electrode 120 are disposed on the front surface of the semiconductor substrate 100, and the first heavily doped layer 111 is disposed between the front electrode 120 and the semiconductor substrate 100. The emitter layer 130 and the back electrode 140 are disposed on the back surface of the semiconductor substrate 100, and the emitter layer 130 is disposed between the back electrode 140 and the semiconductor substrate 100. In the present embodiment, the bottom of the first heavily doped layer 111 is located within the semiconductor substrate 100, and the top surface of the first heavily doped layer 111 is higher than the front surface of the semiconductor substrate 100.

Referring to FIG. 1, the solar cell further includes a second tunneling oxide layer 150, which is disposed between the emitter layer 130 and the semiconductor substrate 100. The second tunneling oxide layer 150 is stacked with the emitter layer 130 and is in contact with the emitter layer 130.

Referring to FIG. 1, the back electrode 140 is electrically connected to the emitter layer 130. Optionally, the back electrode 140 is in direct contact with the emitter layer 130 to achieve electrical connection. In this solar cell, the emitter layer 130 includes a first region and a second region located outside the first region. Referring to FIG. 2, in the present embodiment, the dashed line defined region A is the first region, and the dashed line defined region B is the second region. Optionally, in the emitter layer 130, the second region includes all regions except the first region, or the second region is only a portion of the regions outside the first region. The back electrode is disposed on the first region, and the thickness of the first region is greater than the thickness of the second region.

Referring to FIG. 1, the front electrode 120 is electrically connected to the first heavily doped layer 111. Optionally, the front electrode 120 is in contact with the first heavily doped layer 111 to achieve electrical connection.

Referring to FIG. 1, the solar cell further includes a front passivation film structure disposed on the front surface. The front passivation film structure includes a front first dielectric layer 161 and a front second dielectric layer 162 stacked with each other. The front first dielectric layer 161 is located on the side of the front second dielectric layer 162 adjacent to the semiconductor substrate 100. The front first dielectric layer 161 and the front second dielectric layer 162 are in contact with each other.

Referring to FIG. 1, the solar cell further includes a back passivation film structure disposed on the back surface. The back passivation film structure includes a back first dielectric layer 171 and a back second dielectric layer 172 stacked with each other. The back first dielectric layer 171 is located on the side of the back second dielectric layer 172 adjacent to the semiconductor substrate 100. The back first dielectric layer 171 and the back second dielectric layer 172 are in contact with each other. In the present embodiment, both the front first dielectric layer 161 and the back first dielectric layer 171 are silicon oxide layers, while both the front second dielectric layer 162 and the back second dielectric layer 172 are aluminum oxide layers.

Referring to FIG. 1, the solar cell further includes a front anti-reflection layer 180 and a back anti-reflection layer 190.

A method for preparing the solar cell shown in FIG. 1 can include the following steps.

First, the semiconductor substrate 100 can be cleaned and polished for use in the subsequent steps.

Next, the second tunneling oxide layer 150 and the emitter layer 130 can be formed on the back surface of the semiconductor substrate 100. The second tunneling oxide layer 150 can be directly formed by atomic layer deposition, low-pressure chemical vapor deposition, thermal oxidation, or plasma-enhanced chemical vapor deposition. Alternatively, a silicon layer can be firstly formed on the semiconductor substrate 100, followed by oxidation of the silicon layer to form the second tunneling oxide layer 150. After forming the tunneling oxide layer 150, a polysilicon layer can be deposited thereon. N-type doped polysilicon can be directly formed during the deposition of polysilicon, thereby directly forming the emitter layer 130. Alternatively, a polysilicon layer can be firstly deposited, followed by n-type doping of the polysilicon layer to form the emitter layer 130. The n-type doped polysilicon can be directly formed by introducing a phosphorus source gas during the deposition of polysilicon. The n-type doping of the polysilicon layer can be achieved through phosphorus diffusion.

It can be understood that, in some examples, after forming the emitter layer 130, a step for removing the around deposited material can be performed to remove the polysilicon material deposited on areas of the semiconductor substrate 100 other than the back surface.

After forming the emitter layer 130, a patterned mask layer can be formed on the side of the emitter layer 130 away from the semiconductor substrate 100. The patterned mask layer can cover the first region of the emitter layer 130 and expose the second region of the emitter layer 130. The second region of the emitter layer 130 can then be etched through the patterned mask layer, making the thickness of the first region of the emitter layer 130 greater than the thickness of the second region of the emitter layer 130.

After forming the emitter layer 130, the front surface of the semiconductor substrate 100 can be textured to increase light absorption rate at the front surface of the semiconductor substrate 100. After texturing, a cleaning process can be performed to remove residual materials from the surface of the semiconductor substrate 100.

After forming the emitter layer 130, the passivation film structures can be respectively formed on the front and back surfaces of the semiconductor substrate 100. The steps of forming the passivation film structures include: forming a front first dielectric layer 161, a front second dielectric layer 162, a back first dielectric layer 171, and a back second dielectric layer 172. The front first dielectric layer 161 and the back first dielectric layer 171 can be simultaneously deposited on the semiconductor substrate 100, and similarly, the front second dielectric layer 162 and the back second dielectric layer 172 can be simultaneously deposited on the semiconductor substrate 100.

After forming the passivation film structures, the front anti-reflection layer 180 and the back anti-reflection layer 190 can be formed on the semiconductor substrate 100. The front anti-reflection layer 180 and the back anti-reflection layer 190 can be simultaneously deposited on the semiconductor substrate 100.

After forming the front and back anti-reflection layers 180 and 190, electrode holes can be formed in the layers on both the front and back surfaces of the semiconductor substrate 100. The electrode hole at the front side exposes the semiconductor substrate 100, while the electrode hole at the back side exposes the emitter layer 130. Then, the first heavily doped layer 111 and the front electrode 120 can be formed in the front electrode hole, and the back electrode 140 can be formed in the back electrode hole. The step of forming the first heavily doped layer 111 can include: introducing a doping material into the front electrode hole, and sintering the doping material with the semiconductor substrate 100 to form the first heavily doped layer 111. For example, the doping material can be aluminum, and the semiconductor substrate 100 can include silicon, and thus a p-type aluminum-silicon alloy can be formed by sintering aluminum with silicon and serve as the first heavily doped layer 111. The first heavily doped layer 111 not only inhibits the migration of photo-generated electrons to the back surface for recombination, but also improves the electrical conductivity between the front electrode and the semiconductor substrate 100, since the first heavily doped layer 111 is electrically connected to the front electrode 120, thereby further enhancing the conversion efficiency of the solar cell.

It can be understood that, a solar cell as shown in FIG. 1 can be formed through the above method.

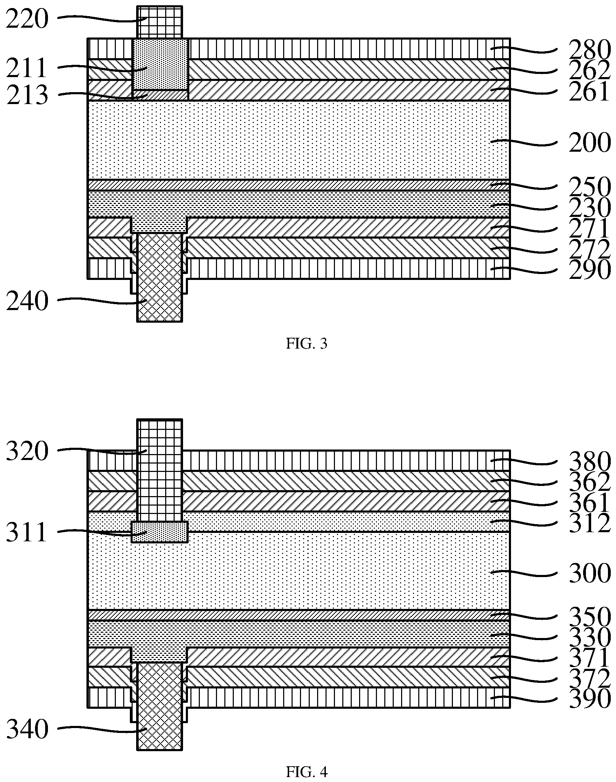

FIG. 3 shows another solar cell structure. Referring to FIG. 3, the solar cell structure includes a semiconductor substrate 200, a first heavily doped layer 211, a front electrode 220, an emitter layer 230, and a back electrode 240. The first heavily doped layer 211 and the front electrode 220 are disposed on the front surface of the semiconductor substrate 200. The first heavily doped layer 211 is disposed between the front electrode 220 and the semiconductor substrate 200. The emitter layer 230 and the back electrode 240 are disposed on the back surface of the semiconductor substrate 200. The emitter layer 230 is disposed between the back electrode 240 and the semiconductor substrate 200.

Referring to FIG. 3, the solar cell further includes a second tunneling oxide layer 250, a front first dielectric layer 261, a front second dielectric layer 262, a back first dielectric layer 271, a back second dielectric layer 272, a front anti-reflection layer 280, and a back anti-reflection layer 290. These layers are generally the same as the corresponding layers as shown in FIG. 1 in location and structure, and reference can be made to the description with respect to FIG. 1.

Referring to FIG. 3, the solar cell further includes a first tunneling oxide layer 213. The first tunneling oxide layer 213 is disposed between the first heavily doped layer 211 and the semiconductor substrate 200. The semiconductor substrate 200 is spaced from the first heavily doped layer 211 by the first tunneling oxide layer 213. The first heavily doped layer 211 can be a p-type doped polysilicon layer, and the first tunneling oxide layer 213 is stacked with the first heavily doped layer 211, and the first tunneling oxide layer 213 can be in contact with the first heavily doped layer 213. As such, the first tunneling oxide layer 213 and the first heavily doped layer 211 form a passivating contact structure on the front side, which can further reduce recombination caused by contact between the front electrode 220 and the semiconductor substrate 200, thereby improving the efficiency of the p-type solar cell.

The method for preparing the solar cell shown in FIG. 3 can generally follow the method for preparing the solar cell shown in FIG. 1, with the main difference being in the formation of the first heavily doped layer 211. Specifically, after forming the front anti-reflection layer 280, an electrode hole can be formed in the layers on the front surface of the semiconductor substrate 200. Then, the first tunneling oxide layer 213 and the first heavily doped layer 211 can be sequentially formed in the electrode hole. The first tunneling oxide layer 213 can be formed by oxidizing the semiconductor substrate 200 to form the first tunneling oxide layer 213 or by depositing the material of the first tunneling oxide layer 213 on the semiconductor substrate 200. The step of forming the first heavily doped layer 211 can include: depositing the first heavily doped layer 211, which is p-type doped, on the first tunneling oxide layer 213. The material of the first heavily doped layer 211 can include p-type doped polysilicon.

FIG. 4 shows another solar cell structure. Referring to FIG. 4, the solar cell includes a semiconductor substrate 300, a first heavily doped layer 311, a front electrode 320, an emitter layer 330, and a back electrode 340. The first heavily doped layer 311 and the front electrode 320 are disposed on the front surface of the semiconductor substrate 300. The first heavily doped layer 311 is disposed between the front electrode 320 and the semiconductor substrate 300. The emitter layer 330 and the back electrode 340 are disposed on the back surface of the semiconductor substrate 300. The emitter layer 330 is disposed between the back electrode 340 and the semiconductor substrate 300.

Referring to FIG. 4, the solar cell further includes a second tunneling oxide layer 350, a front first dielectric layer 361, a front second dielectric layer 362, a back first dielectric layer 371, a back second dielectric layer 372, a front anti-reflection layer 380, and a back anti-reflection layer 390. These layers are generally the same as the corresponding layers as shown in FIG. 1 in location and structure, and reference can be made to the description with respect to FIG. 1.

Referring to FIG. 4, the solar cell further includes a second heavily doped layer 312. The second heavily doped layer 312 is disposed on the semiconductor substrate 300. At least part of the first heavily doped layer 311 is embedded within the second heavily doped layer 312. In addition, the first heavily doped layer 311 is in contact with the semiconductor substrate 300. Optionally, the first heavily doped layer 311 protrudes from the second heavily doped layer 312, with part of the first heavily doped layer 311 embedded within the semiconductor substrate 300. The bottom of the first heavily doped layer 311 is located within the semiconductor substrate 300, while the top of the first heavily doped layer 311 is located within the second heavily doped layer 312. By incorporating the first and second heavily doped layers 311 and 312, the lower doping concentration of the second heavily doped layer 312 can effectively reduce carrier recombination on the semiconductor substrate 300, while the higher doping concentration of the first heavily doped layer 311 can significantly reduce the contact resistance between the first heavily doped layer 311 and the front electrode 320, improving carrier extraction efficiency.

The method for preparing the solar cell shown in FIG. 4 can generally follow the method for preparing the solar cell shown in FIG. 1, with the main difference being in the formation of the first heavily doped layer 311 and the second heavily doped layer 312.

Optionally, before forming the front first dielectric layer 361, the method can further include forming the second heavily doped layer 312 on the semiconductor substrate 300. Optionally, forming the second heavily doped layer 312 can include: depositing a doping material on the front surface of the semiconductor substrate 300, and then sintering the doping material with the material of the semiconductor substrate 300 to form the second heavily doped layer 312. Alternatively, forming the second heavily doped layer 312 can include: depositing a p-type doped second heavily doped layer 312 on the semiconductor substrate 300. The material of the second heavily doped layer 312 can include silicon.

Optionally, after forming the front anti-reflection layer 380, an electrode hole can be formed in the layers on the front surface of the semiconductor substrate 300. The electrode hole penetrates through the second heavily doped layer 312, exposing the semiconductor substrate 300. Then, the first heavily doped layer 311 can be formed in the electrode hole. The step of forming the first heavily doped layer 311 can include: introducing a doping material into the electrode hole, and sintering the doping material with the semiconductor substrate 300 to form the first heavily doped layer 311. For example, the doping material can be aluminum, and the semiconductor substrate 300 can include silicon. A p-type aluminum-silicon alloy can be formed by sintering aluminum with silicon and serve as the first heavily doped layer 311.

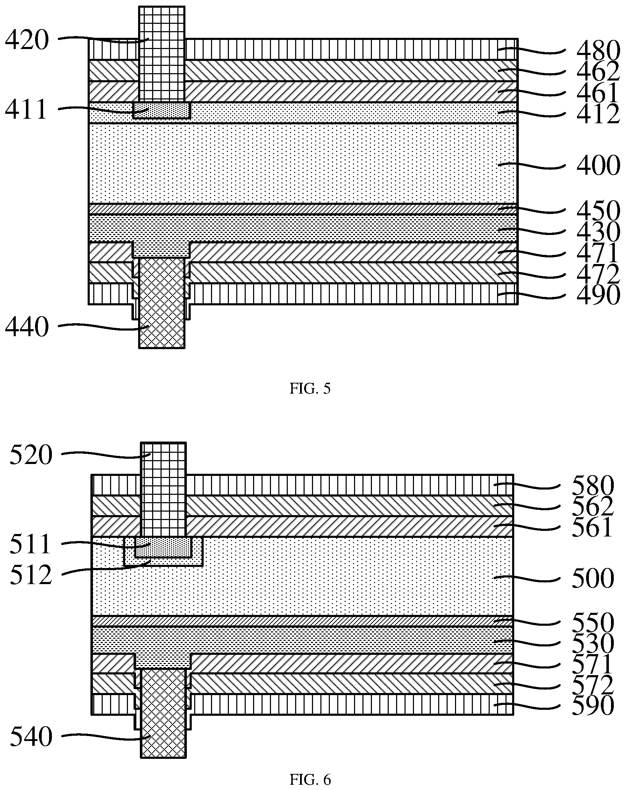

FIG. 5 shows yet another solar cell structure. Referring to FIG. 5, the solar cell includes a semiconductor substrate 400, a first heavily doped layer 411, a front electrode 420, an emitter layer 430, and a back electrode 440. The first heavily doped layer 411 and the front electrode 420 are disposed on the front surface of the semiconductor substrate 400. The first heavily doped layer 411 is disposed between the front electrode 420 and the semiconductor substrate 400. The emitter layer 430 and the back electrode 440 are disposed on the back surface of the semiconductor substrate 400. The emitter layer 430 is disposed between the back electrode 440 and the semiconductor substrate 400.

Referring to FIG. 5, the solar cell further includes a second tunneling oxide layer 450, a front first dielectric layer 461, a front second dielectric layer 462, a back first dielectric layer 471, a back second dielectric layer 472, a front anti-reflection layer 480, and a back anti-reflection layer 490. These layers are generally the same as the corresponding layers as shown in FIG. 1 in location and structure, and reference can be made to the description with respect to FIG. 1.

Referring to FIG. 5, the solar cell further includes a second heavily doped layer 412. The second heavily doped layer 412 is disposed on the semiconductor substrate 400. At least part of the first heavily doped layer 411 is embedded within the second heavily doped layer 412. Optionally, the bottom of the first heavily doped layer 411 is in contact with the second heavily doped layer 412, and the first heavily doped layer 411 is spaced from the semiconductor substrate 400 by the second heavily doped layer 412. Further optionally, the top of the first heavily doped layer 411 is flush with the top of the second heavily doped layer 412, in which case the first heavily doped layer 411 is entirely located within the second heavily doped layer 412.

In other examples, the bottom of the first heavily doped layer 411 can be exposed from the second heavily doped layer 412, in which case the bottom of the first heavily doped layer 411 is in contact with the semiconductor substrate 400. Furthermore, the bottom of the first heavily doped layer 411 can be flush with the second heavily doped layer 412.

The method for preparing the solar cell shown in FIG. 5 can generally follow the method for preparing the solar cell shown in FIG. 1, with the main difference being in the formation of the first heavily doped layer 411 and the second heavily doped layer 412.

Optionally, before forming the front first dielectric layer 461, the method can further include forming the second heavily doped layer 412 on the semiconductor substrate 400. Optionally, forming the second heavily doped layer 412 can include: doping the front surface of the semiconductor substrate 400 to form the second heavily doped layer 412. Alternatively, forming the second heavily doped layer 412 can include: depositing the second heavily doped layer 412, which is p-type doped, on the semiconductor substrate 400. The material of the second heavily doped layer 412 can include silicon. After forming the second heavily doped layer 412, the first heavily doped layer 411 can be formed within the second heavily doped layer 412. The step of forming the first heavily doped layer 411 can include: depositing a doping material on the second heavily doped layer 412, and sintering the doping material with the second heavily doped layer 412 to form the first heavily doped layer 411. For example, the doping material can be aluminum, and the second heavily doped layer 412 can include silicon. A p-type aluminum-silicon alloy can be formed by sintering aluminum with silicon and serve as the first heavily doped layer 411. Alternatively, the step of forming the first heavily doped layer 411 can include: further doping the second heavily doped layer 412 by laser doping to create the first heavily doped layer 411 with a higher doping concentration in the second heavily doped layer 412.

Optionally, the step of forming the first heavily doped layer 411 can be performed after forming the front anti-reflection layer 480. For example, an electrode hole can be formed in the layers on the front surface of the semiconductor substrate 400. The electrode hole extends into the second heavily doped layer 412, exposing the second heavily doped layer 412. Then, the first heavily doped layer 411 can be formed in the electrode hole by using any one of the above-described methods.

FIG. 6 shows yet another solar cell structure. Referring to FIG. 6, the solar cell includes a semiconductor substrate 500, a first heavily doped layer 511, a front electrode 520, an emitter layer 530, and a back electrode 540. The first heavily doped layer 511 and the front electrode 520 are disposed on the front surface of the semiconductor substrate 500. The first heavily doped layer 511 is disposed between the front electrode 520 and the semiconductor substrate 500. The emitter layer 530 and the back electrode 540 are disposed on the back surface of the semiconductor substrate 500. The emitter layer 530 is disposed between the back electrode 540 and the semiconductor substrate 500.

Referring to FIG. 6, the solar cell further includes a second tunneling oxide layer 550, a front first dielectric layer 561, a front second dielectric layer 562, a back first dielectric layer 571, a back second dielectric layer 572, a front anti-reflection layer 580, and a back anti-reflection layer 590. These layers are generally the same as the corresponding layers as shown in FIG. 1 in location and structure, and reference can be made to the description with respect to FIG. 1.

Referring to FIG. 6, the solar cell further includes a second heavily doped layer 512. The second heavily doped layer 412 is disposed on the front surface of the semiconductor substrate 500. At least part of the first heavily doped layer 511 is embedded within the second heavily doped layer 512. The bottom of the first heavily doped layer 511 is in contact with the second heavily doped layer 512, and the first heavily doped layer 41 is spaced from the semiconductor substrate 500 by the second heavily doped layer 512. Optionally, the second heavily doped layer 512 is embedded within the semiconductor substrate 500, and the top surface of the second heavily doped layer 512 is flush with the top surface of the semiconductor substrate 500. Further optionally, the top surface of the first heavily doped layer 511 is flush with the top surface of the second heavily doped layer 512.

In other examples, the bottom of the first heavily doped layer 511 can be exposed from the second heavily doped layer 512, in which case the bottom of the first heavily doped layer 511 is in contact with the semiconductor substrate 500. Furthermore, the bottom of the first heavily doped layer 511 can be flush with the second heavily doped layer 512.

The method for preparing the solar cell shown in FIG. 6 can generally follow the method for preparing the solar cell shown in FIG. 1, with the main difference being in the formation of the first heavily doped layer 511 and the second heavily doped layer 512.

Optionally, forming the second heavily doped layer 512 can include: doping the front surface of the semiconductor substrate 500, converting part of the semiconductor substrate 500 into the second heavily doped layer 512, wherein the doping method can be boron diffusion. Subsequently, the second heavily doped layer 512 is further doped, converting part of the second heavily doped layer 512 into the first heavily doped layer 511, wherein the doping method can be laser doping or boron diffusion.

Optionally, the steps of forming the first heavily doped layer 511 and the second heavily doped layer 512 can be performed after forming the front anti-reflection layer 580. For example, an electrode hole can be formed in the layers on the front surface of the semiconductor substrate 500, exposing the semiconductor substrate 500. Then, the first heavily doped layer 511 and the second heavily doped layer 512 can be formed in the electrode hole by using one of the above-described methods.

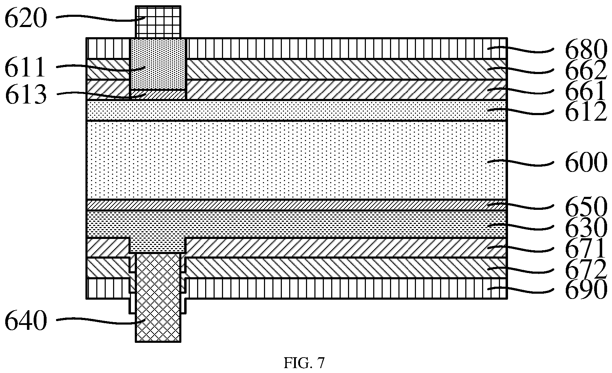

FIG. 7 shows yet another solar cell structure. Referring to FIG. 7, the solar cell includes a semiconductor substrate 600, a first heavily doped layer 611, a front electrode 620, an emitter layer 630, and a back electrode 640. The first heavily doped layer 611 and the front electrode 620 are disposed on the front surface of the semiconductor substrate 600. The first heavily doped layer 611 is disposed between the front electrode 620 and the semiconductor substrate 600. The emitter layer 630 and the back electrode 640 are disposed on the back surface of the semiconductor substrate 600. The emitter layer 630 is disposed between the back electrode 640 and the semiconductor substrate 600.

Referring to FIG. 7, the solar cell further includes a second tunneling oxide layer 650, a front first dielectric layer 661, a front second dielectric layer 662, a back first dielectric layer 671, a back second dielectric layer 672, a front anti-reflection layer 680, and a back anti-reflection layer 690. These layers are generally the same as the corresponding layers as shown in FIG. 1 in location and structure, and reference can be made to the description with respect to FIG. 1.

Referring to FIG. 7, the solar cell further includes a second heavily doped layer 612. The second heavily doped layer 412 is disposed on the semiconductor substrate 600. The first heavily doped layer 611 is stacked on the second heavily doped layer 612. The solar cell further includes a first tunneling oxide layer 613. The first tunneling oxide layer 613 is stacked with the first heavily doped layer 611. The first tunneling oxide layer 613 is disposed between the first heavily doped layer 611 and the second heavily doped layer 612.

The method for preparing the solar cell shown in FIG. 7 can generally follow the method for preparing the solar cell shown in FIG. 2, with the main difference being in the formation of the second heavily doped layer 612.

Optionally, forming the second heavily doped layer 612 can include: doping the front surface of the semiconductor substrate 600 to form the second heavily doped layer 612. Alternatively, forming the second heavily doped layer 612 can include: depositing the second heavily doped layer 612, which is p-type doped, on the semiconductor substrate 600. The material of the second heavily doped layer 612 can include silicon. The step of forming the second heavily doped layer 612 can be performed before forming the front first dielectric layer 661.

The first tunneling oxide layer 613 can be formed by oxidizing the semiconductor substrate 600 to form the first tunneling oxide layer 613, or by depositing the material of the first tunneling oxide layer 613 on the semiconductor substrate 600. The step of forming the first heavily doped layer 611 can include: depositing the first heavily doped layer 611, which is p-type doped, on the first tunneling oxide layer 613. The material of the first heavily doped layer 611 can include p-type doped polysilicon. The steps of forming the first tunneling oxide layer 613 and the first heavily doped layer 611 can be performed after forming the front anti-reflection layer 680. An electrode hole can be formed in the layers on the front surface of the semiconductor substrate 600. Then, the first tunneling oxide layer 613 and the first heavily doped layer 611 can be sequentially formed in the electrode hole.

To better understand the advantages of the solar cell described above, the present disclosure further provides multiple examples and comparative examples. By comparing the examples with the comparative examples, the advantages of the solar cell can become apparent.

### Example 1

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the front surface of the semiconductor substrate. An aluminum paste was screen-printed into the electrode hole and sintered to form a first heavily doped layer and a front electrode. The doping concentration of the first heavily doped layer was 2×10¹⁸cm⁻³.

The anti-reflection layer and the passivation film structure on the back surface were also subjected to laser etching to expose the back surface of the semiconductor substrate. A silver paste was screen-printed to form a back electrode.

### Example 2

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the front surface of the semiconductor substrate. A silicon oxide layer and a boron-doped polysilicon layer were sequentially deposited in the electrode hole to form a second tunneling oxide layer and a first heavily doped layer. The doping concentration of the first heavily doped layer was 2×10¹⁸cm⁻³.

The anti-reflection layer and the passivation film structure on the back surface were also subjected to laser etching to expose the back surface of the semiconductor substrate. A silver paste was screen-printed to form the back electrode.

### Example 3

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

Boron was diffused into the front surface of the semiconductor substrate, thereby forming a second heavily doped layer, which was p-type doped. The doping concentration of the second heavily doped layer was 1×10¹⁷cm³.

A silicon oxide layer with a thickness of 2 nm and an aluminum oxide layer with a thickness of 10 nm were sequentially deposited on both the front and back surfaces of the semiconductor substrate, thereby forming the front and back passivation film structures.

Silicon nitride was deposited on both the front and back surfaces of the semiconductor substrate, thereby forming the anti-reflection layers.

The anti-reflection layer, the passivation film structure, and the second heavily doped layer on the front surface were subjected to laser etching to form an electrode hole that exposed the front surface of the semiconductor substrate. An aluminum paste was screen-printed into the electrode hole and sintered to form the first heavily doped layer and the front electrode. The doping concentration of the first heavily doped layer was 2×10¹⁸cm³.

The anti-reflection layer and the passivation film structure on the back surface were also subjected to laser etching to expose the back surface of the semiconductor substrate. A silver paste was screen-printed to form the back electrode.

### Example 4

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

Boron was diffused into the front surface of the semiconductor substrate, thereby forming a second heavily doped layer, which was p-type doped. The doping concentration of the second heavily doped layer was 1×10¹⁷cm ³.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the second heavily doped layer. An aluminum paste was screen-printed into the electrode hole and sintered to form a first heavily doped layer and a front electrode. The doping concentration of the first heavily doped layer was 2×10¹⁸cm⁻³.

The anti-reflection layer and the passivation film structure on the back surface were also subjected to laser etching to expose the back surface of the semiconductor substrate. A silver paste was screen-printed to form a back electrode.

### Example 5

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. Additional boron was further diffused into the second heavily doped layer, thereby forming a first heavily doped layer. The doping concentration of the second heavily doped layer was 1×10¹⁷cm³. The doping concentration of the first heavily doped layer was 2×10¹⁸cm⁻³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Example 6

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

Boron was diffused into the front surface of the semiconductor substrate, thereby forming a second heavily doped layer, which was p-type doped. The doping concentration of the second heavily doped layer was 1×10¹⁷cm ³.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the second heavily doped layer. A silicon oxide layer and a boron-doped polysilicon layer were sequentially deposited in the electrode hole to form a second tunneling oxide layer and a first heavily doped layer. The doping concentration of the first heavily doped layer was 2×10¹⁸cm⁻³.

The anti-reflection layer and the passivation film structure on the back surface were also subjected to laser etching to expose the back surface of the semiconductor substrate. A silver paste was screen-printed to form a back electrode.

### Example 7

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on the back surface of the semiconductor substrate, thereby forming a back passivation film structure.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. Additional boron was further diffused into the second heavily doped layer, thereby forming a first heavily doped layer. The doping concentration of the second heavily doped layer was 1×10¹⁷cm ³. The doping concentration of the first heavily doped layer was 2×10¹⁸cm⁻³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Example 8

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on the front surface of the semiconductor substrate, thereby forming a front passivation film structure.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. Additional boron was further diffused into the second heavily doped layer, thereby forming a first heavily doped layer. The doping concentration of the second heavily doped layer was 1×10¹⁷cm⁻³. The doping concentration of the first heavily doped layer was 2×10¹⁸cm⁻³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Example 9

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

An aluminum oxide layer with a thickness of 10 nm was deposited on the front surface of the semiconductor substrate, and a silicon oxide layer with a thickness of 2 nm and an aluminum oxide layer with a thickness of 10 nm were sequentially deposited on the back surface of the semiconductor substrate.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. Additional boron was further diffused into the second heavily doped layer, thereby forming a first heavily doped layer. The doping concentration of the second heavily doped layer was 1×10¹⁷cm³. The doping concentration of the first heavily doped layer was 2×10¹⁸cm⁻³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Example 10

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. Additional boron was further diffused into the second heavily doped layer, thereby forming a first heavily doped layer. The doping concentration of the second heavily doped layer was 1×10¹⁷cm³. The doping concentration of the first heavily doped layer was 2×10¹⁸cm⁻³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Example 11

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. Additional boron was further diffused into the second heavily doped layer, thereby forming a first heavily doped layer. The doping concentration of the second heavily doped layer was 1×10¹⁷cm³. The doping concentration of the first heavily doped layer was 2×10¹⁸cm⁻³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Comparative Example 1

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. The doping concentration of the second heavily doped layer was 1×10¹⁷cm³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Comparative Example 2

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

A patterned mask layer was formed on the back surface of the emitter layer, covering the first region and exposing the second region. The second region was then etched to reduce the thickness of the second region to 50 nm.

The front surface of the semiconductor substrate was textured.

An aluminum oxide layer with a thickness of 10 nm was deposited on the front surface of the semiconductor substrate, and a silicon oxide layer with a thickness of 2 nm and an aluminum oxide layer with a thickness of 10 nm were sequentially deposited on the back surface of the semiconductor substrate.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. The doping concentration of the second heavily doped layer was 1×10¹⁷cm³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Comparative Example 3

A p-type silicon wafer as a semiconductor substrate was cleaned and polished.

A silicon oxide layer with a thickness of 2 nm as a first tunneling oxide layer was deposited on the back surface of the p-type silicon wafer. A phosphorus-doped polysilicon layer with a thickness of 100 nm as an emitter layer was deposited on the back surface of the first tunneling oxide layer. The materials deposited around the front and side surfaces were removed.

The front surface of the semiconductor substrate was textured.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the semiconductor substrate. Boron was diffused into the semiconductor substrate through the electrode hole, thereby forming a second heavily doped layer. The doping concentration of the second heavily doped layer was 1×10¹⁷cm³.

An aluminum paste was screen-printed into the electrode hole to form a front electrode. The anti-reflection layer and the passivation film structure on the back surface were also subjected to laser etching to expose the back surface of the semiconductor substrate. A silver paste was screen-printed to form a back electrode.

### Comparative Example 4

A p-type silicon wafer as a semiconductor substrate was cleaned and polished.

The front surface of the semiconductor substrate was textured.

A silicon oxide layer with a thickness of 2 nm as a first tunneling oxide layer was deposited on the front surface of the p-type silicon wafer. A phosphorus-doped polysilicon layer with a thickness of 100 nm as an emitter layer was deposited on the front surface of the first tunneling oxide layer. The materials deposited around the back and side surfaces were removed.

A silicon oxide layer with a thickness of 2 nm and an aluminum oxide layer with a thickness of 10 nm were sequentially deposited on both the front and back surfaces of the semiconductor substrate, thereby forming front and back passivation film structures.

Silicon nitride was deposited on both the front and back surfaces of the semiconductor substrate, thereby forming anti-reflection layers.

The anti-reflection layer and the passivation film structure on the front surface were subjected to laser etching to form an electrode hole that exposed the emitter layer. An aluminum paste was screen-printed into the electrode hole to form a front electrode.

The anti-reflection layer and the passivation film structure on the back surface were also subjected to laser etching to expose the back surface of the semiconductor substrate. A silver paste was screen-printed to form a back electrode.

Testing: The conversion efficiency of the solar cells fabricated according to the above examples and comparative examples was tested. The results can be found in Table 1.

**Table 1**

| | Conversion efficiency (%) | Open-circuit voltage (mV) | Short-circuit current density (mA/cm²) | Fill factor (%) |
|---|---|---|---|---|
| Example 1 | 24.0 | 700 | 41.5 | 82.5 |
| Example 2 | 25.1 | 717 | 41.9 | 83.2 |
| Example 3 | 24.1 | 705 | 41.4 | 82.5 |
| Example 4 | 24.5 | 708 | 41.6 | 83.1 |
| Example 5 | 24.9 | 716 | 41.7 | 83.3 |
| Example 6 | 25.2 | 718 | 42 | 83.4 |
| Example 7 | 24.3 | 707 | 41.5 | 82.7 |
| Example 8 | 24.3 | 708 | 41.7 | 82.4 |
| Example 9 | 24.5 | 709 | 41.8 | 82.6 |
| Example 10 | 24.6 | 710 | 41.9 | 82.8 |
| Example 11 | 24.8 | 716 | 41.8 | 83 |
| Comparative Example 1 | 23.7 | 697 | 41.1 | 82.7 |
| Comparative Example 2 | 23.6 | 692 | 41.2 | 82.8 |
| Comparative Example 3 | 23.5 | 694 | 40.8 | 83 |
| Comparative Example 4 | 22.0 | 680 | 40.2 | 80.5 |

Referring to Table 1, compared to Comparative Examples 1 to 5, the conversion efficiency of the solar cells in Examples 1 to 11 shows a significant improvement, which indicates that the solar cells in the present application have higher conversion efficiencies, mainly due to the positioning of the p-n junction on the back surface of the semiconductor substrate and the addition of the first heavily doped layer on the front surface, which creates a high-low junction on the front side, thereby suppressing the recombination of photo-generated carriers migrating to the back surface. Furthermore, referring to Examples 1 and 3, the addition of the second heavily doped layer based upon the above structure further enhances the efficiency of the solar cells.

It should be noted that above examples are provided for illustrative purposes and do not imply any limitation on the scope of the present disclosure.

It should be understood that, unless otherwise specified herein, the sequence of the steps is not strictly limited, and the steps can be performed in other sequences. Moreover, at least some of the steps can include multiple sub-steps or multiple stages, these sub-steps or stages are not necessarily performed at the same time, but can be performed at different times. These sub-steps or stages are not necessarily to be sequentially performed, but can be performed alternately or in turn with at least some of the sub-steps or stages of other steps.

The various embodiments in the present disclosure are described in a progressive manner, with each embodiment focusing on the differences from other embodiments. Identical or similar parts can be mutually referred to across the embodiments.

The technical features in the above embodiments can be combined arbitrarily. To keep the description concise, not all possible combinations of the technical features have been described in the embodiments. However, as long as there is no contradiction in the combinations of these technical features, the combinations should be considered as in the scope of the present disclosure.

## Claims

1. A solar cell, comprising a semiconductor substrate, a first heavily doped layer, a front electrode, an emitter layer, and a back electrode;
wherein the semiconductor substrate is first-type doped and comprises opposing front and back surfaces;
wherein the first heavily doped layer and the front electrode are disposed on the front surface of the semiconductor substrate, the first heavily doped layer is first-type doped, a doping concentration of the first heavily doped layer is higher than a doping concentration of the semiconductor substrate, the first heavily doped layer is disposed between the front electrode and the semiconductor substrate, and the front electrode is electrically connected to the semiconductor substrate through the first heavily doped layer;
wherein the emitter layer and the back electrode are disposed on the back surface of the semiconductor substrate, the emitter layer is second-type doped, the second type is different from the first type, and the emitter layer is disposed between the back electrode and the semiconductor substrate.

2. The solar cell according to claim 1, wherein an orthographic projection of the front electrode on the semiconductor substrate is located within an orthographic projection of the first heavily doped layer on the semiconductor substrate.

3. The solar cell according to claim 1, wherein the front electrode is in direct contact with the first heavily doped layer.

4. The solar cell according to claim 1, wherein the first heavily doped layer is stacked on the semiconductor substrate.

5. The solar cell according to claim 1, wherein a portion of the first heavily doped layer is embedded within the semiconductor substrate.

6. The solar cell according to claim 1, further comprising a second heavily doped layer disposed on the front surface of the semiconductor substrate, wherein the second heavily doped layer is first-type doped, and a doping concentration of the second heavily doped layer is higher than the doping concentration of the semiconductor substrate but lower than the doping concentration of the first heavily doped layer; an electric field that hinders movement of front side carriers is formed between the second heavily doped layer and the semiconductor substrate.

7. The solar cell according to claim 6, wherein the doping concentration of the first heavily doped layer is in a range from 1×10¹⁸cm⁻³ to 3×10¹⁸cm⁻³, and the doping concentration of the second heavily doped layer is in a range from 5×10¹⁶cm⁻³ to 9×10¹⁷cm⁻³.

8. The solar cell according to claim 6, wherein an orthographic projection of the first heavily doped layer on the semiconductor substrate is located within an orthographic projection of the second heavily doped layer on the semiconductor substrate.

9. The solar cell according to claim 8, wherein at least part of the first heavily doped layer is embedded within the second heavily doped layer.

10. The solar cell according to claim 9, wherein the first heavily doped layer is exposed from the second heavily doped layer and is in contact with the semiconductor substrate.

11. The solar cell according to claim 9, wherein the first heavily doped layer is spaced apart from the semiconductor substrate by the second heavily doped layer.

12. The solar cell according to claim 9, wherein the second heavily doped layer is stacked on the semiconductor substrate.

13. The solar cell according to claim 12, wherein a portion of the first heavily doped layer is embedded within the semiconductor substrate.

14. The solar cell according to claim 12, wherein the first heavily doped layer is embedded within the second heavily doped layer, and a top surface of the first heavily doped layer is flush with a top surface of the second heavily doped layer.

15. The solar cell according to claim 9, wherein the second heavily doped layer is embedded within the semiconductor substrate, the first heavily doped layer is embedded within the second heavily doped layer, and top surfaces of the first heavily doped layer, the second heavily doped layer, and the semiconductor substrate are flush with each other.

16. The solar cell according to claim 9, wherein the first heavily doped layer is stacked on a side of the second heavily doped layer away from the semiconductor substrate.

17. The solar cell according to claim 16, wherein the second heavily doped layer is stacked on the semiconductor substrate.

18. The solar cell according to any one of claims 1 to 17, wherein the first type doping is p-type doping, and the second type doping is n-type doping.

19. The solar cell according to claim 18, wherein the first heavily doped layer comprises a first-type doped polysilicon layer, and the solar cell further comprises a first tunneling oxide layer disposed between the first-type doped polysilicon layer and the semiconductor substrate.

20. The solar cell according to claim 19, wherein the emitter layer comprises a second-type doped polysilicon layer, and the solar cell further comprises a second tunneling oxide layer disposed between the second-type doped polysilicon layer and the semiconductor substrate.

21. The solar cell according to any one of claims 1 to 14 and 16 to 17, wherein the emitter layer comprises a first region and a second region located outside the first region, the back electrode is disposed on the first region, and a thickness of the first region is greater than a thickness of the second region.

22. The solar cell according to claim 21, wherein a thickness difference between the first region and the second region is in a range from 20 nm to 120 nm.

23. The solar cell according to any one of claims 1 to 14, 16 to 17, and 19, further comprising a layer stacked on the front surface.

24. The solar cell according to any one of claims 1 to 14, 16 to 17, and 19, the passivation film structure disposed on the back surface, wherein the passivation film structure comprises a first dielectric layer and a second dielectric layer sequentially stacked in a direction away from the semiconductor substrate.

25. The solar cell according to claim 24, wherein the first dielectric layer is a silicon oxide layer or a silicon oxynitride layer, and the second dielectric layer is an aluminum oxide layer.

26. The solar cell according to claim 24, wherein a thickness of the first dielectric layer is in a range from 0.1 nm to 2 nm, and a thickness of the second dielectric layer is in a range from 3 nm to 20 nm.

27. A method for preparing a solar cell comprising following steps:
forming a first heavily doped layer on a front surface of a semiconductor substrate, both the semiconductor substrate and the first heavily doped layer being first-type doped, a doping concentration of the first heavily doped layer being higher than a doping concentration of the semiconductor substrate;
forming a front electrode on a side of the first heavily doped layer away from the semiconductor substrate, the front electrode being electrically connected to the semiconductor substrate through the first heavily doped layer;
forming an emitter layer on a back surface of the semiconductor substrate, the emitter layer being second-type doped, the second-type doping being different from the first-type doping; and
forming a back electrode on a side of the emitter layer away from the semiconductor substrate.

28. The method according to claim 27, further comprising a step of forming a second heavily doped layer on the front surface of the semiconductor substrate, wherein the second heavily doped layer is first-type doped, a doping concentration of the second heavily doped layer is higher than the doping concentration of the semiconductor substrate and lower than the doping concentration of the first heavily doped layer, and an electric field that hinders movement of front side carriers is formed between the second heavily doped layer and the semiconductor substrate.

29. The method according to claim 28, wherein the step of forming the second heavily doped layer is performed before the step of forming the first heavily doped layer, and the step of forming the first heavily doped layer comprises:
forming the first heavily doped layer at least partially within the second heavily doped layer, such that at least part of the first heavily doped layer is encapsulated within the second heavily doped layer.

30. The method according to claim 29, wherein the step of forming the first heavily doped layer at least partially within the second heavily doped layer comprises:
forming a through-hole in the second heavily doped layer, the through-hole penetrating through the second heavily doped layer and exposing the semiconductor substrate;
introducing a doping material into the through-hole; and
sintering the doping material with a material of the semiconductor substrate, thereby forming the first heavily doped layer.

31. The method according to claim 29, wherein
forming a groove in the second heavily doped layer, with the second heavily doped layer defining a bottom of the groove;
introducing a doping material into the groove; and
sintering the doping material with a material of the second heavily doped layer, thereby forming the first heavily doped layer.

32. The method according to claim 29, wherein
laser doping a material of the second heavily doped layer, thereby forming the first heavily doped layer.

33. The method according to claim 29, wherein the step of forming the second heavily doped layer is performed before the step of forming the first heavily doped layer, the first heavily doped layer is formed on a side of the second heavily doped layer away from the semiconductor substrate, and the formed first heavily doped layer is stacked on the second heavily doped layer.

34. The method according to any one of claims 27 to 33, further comprising a step of forming a passivation film structure on the front surface of the semiconductor substrate, wherein the step of forming the passivation film structure comprises:
sequentially forming a first dielectric layer and a second dielectric layer stacked in a direction away from the semiconductor substrate.

35. The method according to any one of claims 27 to 33, further comprising a step of forming a passivation film structure on the back surface of the semiconductor substrate, wherein the step of forming the passivation film structure comprises:
sequentially forming a first dielectric layer and a second dielectric layer stacked in a direction away from the semiconductor substrate.

36. The method according to any one of claims 27 to 33, wherein the emitter layer comprises a first region and a second region located outside the first region, in the step of forming the back electrode, the back electrode is formed on a side of the first region away from the semiconductor substrate; and
after forming the emitter layer, the method further comprises:
etching the second region, such that a thickness of the first region is greater than a thickness of the second region.
